# FASCICULE DE BREVET EUROPEEN

(11) **EP 4 346 077 B1**
(45) Date de publication et mention de la délivrance du brevet: **29.10.2025**
(21) Numéro de dépôt: 23199917.8
(22) Date de dépôt: 26.09.2023
(51) Int. Cl.: H02M 3/158, H02M 3/335

(54) **COMMANDE D'UN TRANSISTOR**
TRANSISTORSTEUERUNG
CONTROLLING A TRANSISTOR

(30) Priorité: 30.09.2022 FR 2209951
(43) Date de publication de la demande: 03.04.2024
(73) Titulaire: STMicroelectronics (Tours) SAS, 37100 Tours (FR)
(72) Inventeur: CISSE, Diawoye, 37100 TOURS (FR); RIVET, Bertrand, 37210 VOUVRAY (FR); GAUTIER, Frederic, 37380 MONNAIE (FR)
(74) Mandataire: Cabinet Beaumont

(56) Documents cités:
- US-A1- 2019 165 686
- US-A1- 2022 158 565

## Description

### Domaine technique

La présente description concerne de façon générale les systèmes et dispositifs électroniques, et plus particulièrement, les circuits et procédé de commande de transistors, et plus précisément des transistors de type MOS à canal N.

### Technique antérieure

En électronique, il est courant que certains composants soient accompagnés d'un circuit de commande permettant de les faire fonctionner au mieux.

Les transistors sont fréquemment associés à un circuit de commande leur appliquant une tension de commande sur leur borne de commande.

Un exemple de circuit et de procédé de commande d'un transistor dans lequel le transistor est piloté à partir de la tension reçue entre ses bornes de drain et de source est divulgué dans le document US 2019/0165686 A1.

Il serait souhaitable de pouvoir améliorer, au moins en partie, certains aspects des circuits de commande de transistors.

### Résumé de l'invention

Il existe un besoin pour des circuits de commande de transistors plus performants.

Il existe un besoin pour des circuits de commande de transistors permettant de limiter les pertes de courant lors des changements d'état du transistor.

Il existe un besoin pour des circuits de commande de transistors auto-alimentés.

Un mode de réalisation pallie tout ou partie des inconvénients des circuits de commande connus de transistors.

Un mode de réalisation prévoit un procédé de commande d'un transistor MOS à canal N selon les caractéristiques de la revendication indépendante 1.

D'autres modes de réalisation sont définis dans les revendications dépendantes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, très schématiquement et sous forme de blocs, un mode de réalisation général d'un circuit de commande d'un transistor ;
la figure 2 représente, schématiquement et partiellement sous forme de blocs, un exemple d'application du mode de réalisation de la figure 1 ;
la figure 3 représente, schématiquement et partiellement sous forme de blocs, un autre exemple d'application du mode de réalisation de la figure 1 ;
la figure 4 représente, schématiquement et sous forme de blocs, un premier mode de réalisation plus détaillé d'un circuit de commande d'un transistor ;
la figure 5 représente des chronogrammes illustrant le fonctionnement du mode de réalisation de la figure 4 ;
la figure 6 représente, schématiquement, un exemple de réalisation d'une partie du mode de réalisation de la figure 4 ;
la figure 7 représente, schématiquement et sous forme de blocs, un deuxième mode de réalisation plus détaillé d'un circuit de commande d'un transistor ;
la figure 8 représente un schéma-bloc illustrant un procédé de mise en oeuvre du mode de réalisation de la figure 7 ;
la figure 9 représente, schématiquement, un exemple de réalisation d'une partie du mode de réalisation de la figure 7 ; et
la figure 10 représente, schématiquement et sous forme de blocs, un troisième mode de réalisation plus détaillé d'un circuit de commande d'un transistor.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

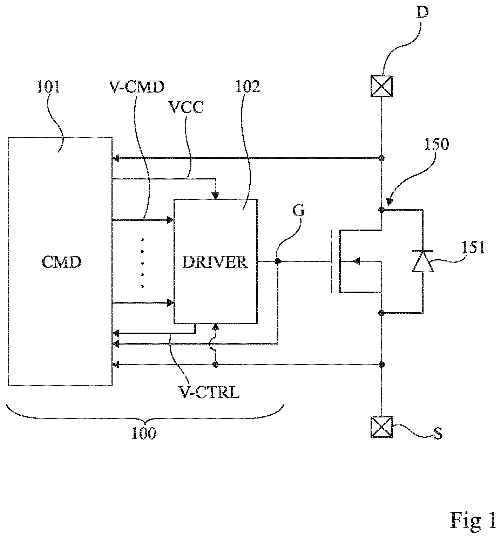

La figure 1 représente, très schématiquement et sous forme de blocs, un mode de réalisation d'un dispositif électronique comprenant un transistor 150 et son circuit de commande 100.

Le transistor 150 est un transistor à effet de champ à grille isolée, ou transistor de type MOSFET (Metal Oxide Semiconductor Field Effect Transistor), aussi appelé transistor de type MOS. De plus, et plus particulièrement, le transistor 150 est un transistor de type MOS à canal N, aussi appelé transistor NMOS. Le transistor 150 comprend deux bornes de conduction et une borne de commande. Une première borne de conduction est la borne de drain du transistor 150, et est reliée, de préférence connectée, à un noeud de drain D. Une deuxième borne de conduction est la borne de source du transistor 150 et est reliée, de préférence connectée, à un noeud de source S. La borne de commande du transistor 150 est la borne de grille du transistor 150 et est reliée, de préférence connectée, à un noeud de grille G. De plus, comme tout transistor de type MOS, le transistor 150 comprend une diode parasite, représentée en figure 1 par une diode 151 dont l'anode est reliée, de préférence connectée, au noeud de de source S, et dont la cathode est reliée, de préférence connectée, au noeud de drain D.

Le circuit de commande 100 est un circuit relié aux noeuds de source S, de drain D, et de grille G du transistor 150, et permettant de fournir entre le noeud de grille G et le noeud de source S une tension de commande du transistor. Le circuit de commande 100 comprend une unité de commande 101, ou circuit de commande 101, et un circuit de pilotage 102. Le circuit de commande 100 a la particularité de s'autoalimenter à partir de la tension reçue entre les bornes de drain et de source du transistor 150. Le circuit de commande 100 a aussi la particularité de s'autocommander à partir de la tension reçue entre les bornes de drain et de source du transistor 150.

L'unité de commande 101 comprend des circuits logiques permettant de fournir plusieurs tensions de commande V-CMD au circuit de pilotage 102, et au moins un circuit d'alimentation permettant de fournir une tension d'alimentation VCC au circuit de pilotage 102. Pour cela, l'unité de commande 101 est reliée, de préférence connectée, aux noeuds D, S et G du transistor 150. L'unité de commande peut, en outre, recevoir une ou plusieurs tensions de contrôle V-CTRL de la part du circuit de pilotage 102. L'unité de commande ne reçoit pas de tension d'alimentation extérieure.

Le circuit de pilotage 102 est un circuit adapté à fournir une tension de commande entre les noeuds G et S destinée au transistor 150, en se basant sur les tensions de commande V-CMD fournies par l'unité de commande 100.

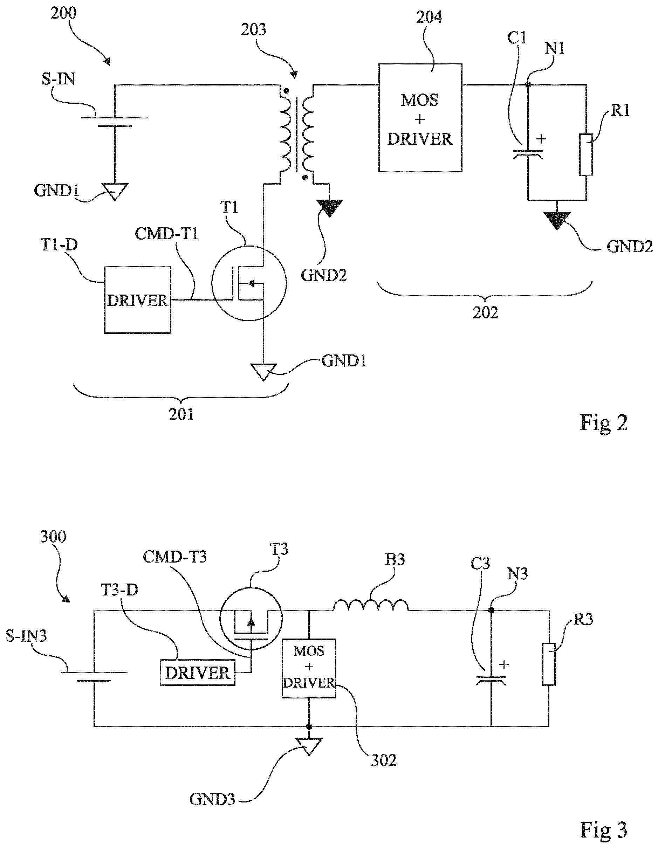

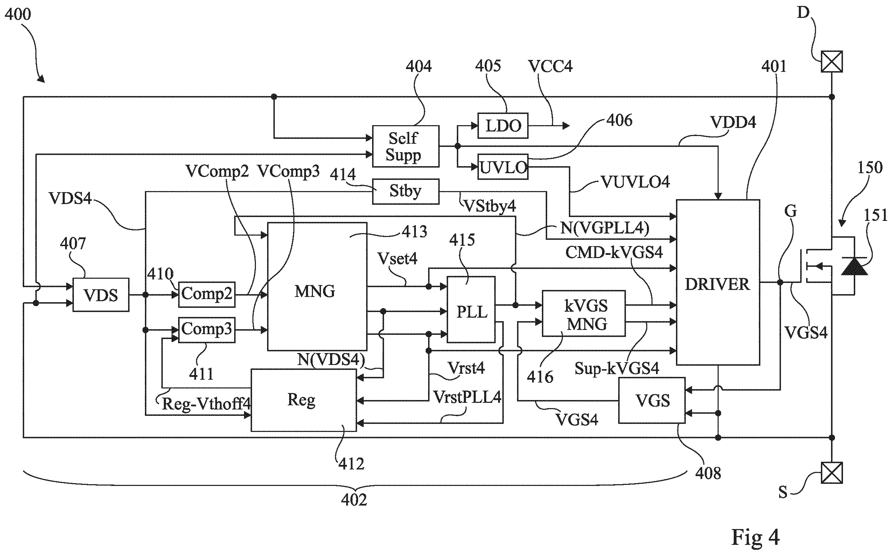

Des exemples d'application du transistor 150 associé au circuit de commande 100 sont décrits en relation avec les figures 2 et 3. Des exemples détaillés du circuit de commande 100 sont décrits en relation avec les figures 4 à 10.

La figure 2 représente un exemple de réalisation d'un circuit 200 convertisseur à découpage à transformateur, aussi appelé convertisseur flyback, utilisant un dispositif du type de celui décrit en relation avec la figure 1. Dit autrement, le circuit 200 est une alimentation à découpage utilisant un transformateur.

Le circuit 200 comprend un étage primaire 201 et un étage secondaire 202 séparés par un transformateur 203. Plus particulièrement, le transformateur 203 est composé d'une première bobine reliée à l'étage primaire 201, et une deuxième bobine reliée à l'étage secondaire 202.

L'étage primaire 201 comprend, par exemple, une source de tension d'entrée S-IN fournissant une tension d'entrée, et un transistor MOS à canal N T1 associé à un circuit de pilotage T1-D (DRIVER). La source de tension S-IN comprend une première borne reliée à une borne de la première bobine du transformateur 203, et une deuxième borne reliée, de préférence connectée, à un premier noeud de référence GND1 recevant un premier potentiel de référence. Le transistor T1 est disposé pour relier une deuxième borne, différente de la première borne, de la première bobine du transformateur, au premier noeud de référence GND1. Plus particulièrement, le drain du transistor T1 est relié, de préférence connecté, à la deuxième borne de la première bobine du transformateur 203, et la source du transistor T1 est reliée, de préférence connectée, au premier noeud de référence GND1. La grille du transistor T1 reçoit une tension de commande CMD_T1 de la part du circuit de pilotage T1-D.

L'étage secondaire 202 comprend, par exemple, un dispositif 204 (MOS + DRIVER) du type du dispositif décrit en relation avec la figure 1, un condensateur C1 et une résistance R1. Le dispositif 204 comprend une première borne, correspondant à la borne de source du dispositif de la figure 1, et qui est reliée, de préférence connectée, à une première borne de la deuxième bobine du transformateur 203. Le dispositif 204 comprend une deuxième borne correspondant à la borne de drain du dispositif de la figure 1 et qui est reliée, de préférence connectée, à un noeud de sortie N1. Le condensateur C1 et la résistance R1 sont disposés en parallèle entre le noeud N1 et un deuxième noeud de référence GND2 recevant un deuxième potentiel de référence différent du premier potentiel de référence. La deuxième borne de la deuxième bobine du transformateur 203 est, en outre, reliée, de préférence connectée, au deuxième noeud de référence GND2. La résistance R1 représente une charge disposée en sortie du circuit 200.

Le fonctionnement du circuit 200 est le fonctionnement usuel d'un convertisseur de type flyback. Le circuit 200 présente deux états qui s'alternent lorsque le circuit 200 est en fonctionnement.

Dans un premier état, dit état passant, le transistor T1 est conducteur, la première bobine du transformateur 203 est reliée directement à la source de tension d'entrée S-IN. Il en résulte une augmentation du flux magnétique dans le transformateur 203. La tension au niveau de la deuxième bobine du transformateur est négative, et le transistor du dispositif 204 est commandé pour ne pas être passant. La charge R1 disposée entre les noeuds N1 et GND2 reçoit alors de l'énergie de la part du condensateur C1.

Dans un deuxième état, dit état bloqué, le transistor T1 est commandé pour ne pas être conducteur, et le transistor du dispositif 204 est commandé pour être conducteur. L'énergie stockée dans le transformateur 203 est utilisée pour charger le condensateur C1 et pour alimenter la charge R1 disposée entre les noeuds N1 et GND.

Ainsi, pour faire fonctionner le circuit 200, le transistor T1 et le transistor du dispositif 204 sont commandés en opposition, généralement par des signaux créneaux en opposition de phase.

La figure 3 représente un exemple de réalisation d'un circuit 300 convertisseur buck, c'est-à-dire un circuit convertisseur abaisseur, utilisant un dispositif du type de celui décrit en relation avec la figure 1. De façon générale, un circuit convertisseur buck est une alimentation à découpage qui convertit une tension continue en une autre tension continue de plus faible valeur.

Le circuit 300 comprend :
- une source de tension d'entrée S-IN3 ;
- un transistor T3 de type MOS à canal P associé à un circuit de pilotage T3-D (DRIVER) ;
- un dispositif 302 (MOS+DRIVER) du type du dispositif décrit en relation avec la figure 1 ;
- une bobine B3 ;
- un condensateur C3 ; et
- une résistance R3.

La source de tension d'entrée S-IN3 est reliée entre la borne de source du transistor T3 et un noeud de référence GND3 recevant un potentiel de référence, par exemple la masse. Le circuit de pilotage T3-D est adapté à fournir une tension de commande CMD-T3 à la grille du transistor T3.

Le dispositif 302 comprend une première borne correspondant à la borne de drain du transistor compris dans le dispositif 302, cette première borne étant reliée, de préférence connectée, à la borne de drain du transistor T3. Le dispositif 302 comprend, en outre, une deuxième borne correspondant à la borne de source du transistor compris dans le dispositif 302, cette deuxième borne étant reliée, de préférence connectée, au noeud de référence GND3. En étant disposé ainsi, le dispositif 302 fait partie de l'étage secondaire du circuit 300.

La bobine B3 comprend une première borne reliée, de préférence connectée, à la borne de drain du transistor T3, et une deuxième borne reliée, de préférence connectée, à un noeud de sortie N3. Le condensateur C3 et la résistance R3 sont disposés en parallèle entre les noeuds N3 et GND3. La résistance R3 représente une charge disposée en sortie du circuit 200.

Le fonctionnement du circuit 300 est le fonctionnement usuel d'un convertisseur de type buck. Le circuit 200 présente deux états qui s'alternent lorsque le circuit 200 est en fonctionnement.

Dans un premier état, dit état passant, le transistor T3 est conducteur, la bobine B3 est reliée directement à la source de tension d'entrée S-IN. Il en résulte une augmentation du flux magnétique dans la bobine B3. La tension au niveau du dispositif 302 est négative, et le transistor du dispositif 302 est commandé pour ne pas être passant. La charge R3 disposée entre les noeuds N3 et GND3 reçoit alors de l'énergie de la part du condensateur C3.

Dans un deuxième état, dit état bloqué, le transistor T3 est commandé pour ne pas être conducteur, et le transistor du dispositif 302 est commandé pour être conducteur. L'énergie stockée dans la bobine B3 est transférée pour charger le condensateur C1 et pour alimenter la charge R3 disposée entre les noeuds N3 et GND3.

Ainsi, pour faire fonctionner le circuit 300, le transistor T3 et le transistor du dispositif 302 sont commandés en opposition, généralement par des signaux créneaux en opposition de phase.

La figure 4 illustre, sous forme de blocs et de façon plus précise, un premier mode de réalisation d'un dispositif du type du dispositif de la figure 1. Plus particulièrement, la figure 4 illustre un premier mode de réalisation d'un dispositif électronique comprenant le transistor 150 et son circuit de commande 400 du type du circuit de commande 100 décrit en relation avec la figure 1.

Le circuit de commande 400 comprend, comme le circuit de commande 100 de la figure 1, un circuit de pilotage 401 (DRIVER) fournissant une tension de commande VGS4 au transistor 150. Pour cela, le circuit de pilotage 401 est relié, de préférence connecté, aux bornes G et S du transistor 150. De plus, le circuit de pilotage 401 reçoit une tension d'alimentation VDD4, et plusieurs tensions de commande détaillées ci-après.

Le circuit de commande 400 comprend, en outre, d'autres circuits faisant tous partie d'une unité de commande 402 du type de l'unité de commande 101 décrite en relation avec la figure 1.

L'unité de commande 402 comprend des circuits d'alimentation fournissant la tension d'alimentation VDD4 à partir de la tension présente entre les bornes de drain D et de source S du transistor 150. Les circuits d'alimentation comportent, par exemple :
- un circuit d'auto-alimentation 404 (Self Supp) ;
- un régulateur de tension 405 (LDO) (Liner and Low Drop Out circuit) ;
- un circuit de verrouillage de sous-tension 406 (UVLO) (Under voltage Lock Out circuit).

Le circuit d'auto-alimentation 404 comprend deux entrées reliées, de préférence connectées, aux bornes D et S, et une sortie fournissant la tension d'alimentation VDD4. Le régulateur de tension 405 reçoit, en entrée, la tension d'alimentation VDD4, et fournit, en sortie, une tension d'alimentation VCC4 dont l'amplitude est inférieure à la tension d'alimentation VDD4 ; cette tension d'alimentation VCC4 est utilisée, par exemple, pour alimenter les différents circuits de l'unité de commande 402, ainsi que pour alimenter le circuit de pilotage 401. Le circuit de verrouillage de sous-tension 406 reçoit, en entrée, la tension d'alimentation VDD4, et fournit, en sortie, une tension de commande VUVLO. La tension de commande VUVLO est envoyée au circuit de pilotage 401 et permet de lui indiquer si la tension d'alimentation VDD4 devient trop faible pour l'alimenter. Selon un exemple, si la tension d'alimentation VDD4 devient inférieure à une tension de seuil alors, la tension de commande VUVLO change d'état et le circuit de pilotage 401 peut en prendre compte, par exemple pour rendre le transistor 150 non conducteur et ainsi laisser la diode parasite 151 devenir conductrice.

L'unité de commande 402 comprend, en outre, des circuits de mesure de tension, parmi lesquels :
- un circuit de mesure 407 (VDS) de la tension drain-source du transistor 150 relié, de préférence connecté, aux bornes D et S du transistor 150, et fournissant, en sortie, une tension VDS4 représentative de la tension drain-source du transistor 150 ; et
- un circuit de mesure 408 de la tension grille-source du transistor 150 relié, de préférence connecté, aux bornes G et S du transistor 150 et fournissant, en sortie, une tension VGS4 représentative de la tension grille-source du transistor 150.

L'unité de commande 402 comprend, en outre, des circuits de comparaison de tension 410 (Comp2) et 411 (Comp3), ou circuit de détection de seuil par comparaison 410 et 411.

Le circuit de comparaison 410 reçoit, en entrée, la tension VDS4, et fournit en sortie une tension de comparaison VComp2. Le circuit de comparaison 410 est adapté à comparer la valeur de l'amplitude de la tension VDS4 à une tension de seuil VTHON4 représentant le niveau de tension entre les bornes D et S du transistor 150 atteint lorsque la diode parasite 151 du transistor 150 devient conductrice. Ce phénomène arrive quand une tension de commande visant à rendre le transistor 150 non conducteur est imposée à sa grille mais que la tension mesurée entre ses bornes de drain et de source est trop élevée en valeur absolue, à cause de la mise en conduction de la diode parasite 151.

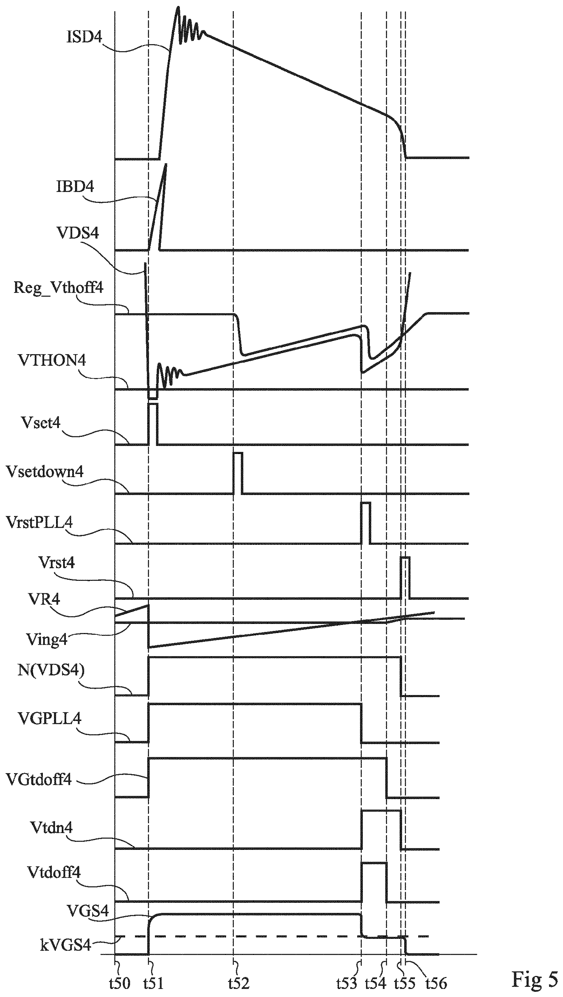

Le circuit de comparaison 411 reçoit, en entrée, la tension VDS4, et fournit en sortie une tension de comparaison VComp1. Le circuit de comparaison 411 est adapté à comparer la valeur de l'amplitude de la tension VDS4 à une tension Reg_Vthoff4 permettant de déterminer le moment où la tension drain-source du transistor 150 s'inverse. Le rôle de la tension Reg_Vthoff4 est décrit plus en détail en relation avec la figure 5.

L'unité de commande 402 comprend, en outre et selon un mode de réalisation, un circuit de génération 412 de la tension Reg_Vthoff4, recevant, en entrée les tensions suivantes :
- la tension VDS4 ;
- une tension N(VDS4) représentant l'état de conduction du transistor 150, plus particulièrement quand le transistor est conducteur la tension N(VDS4) est à un état haut, et quand le transistor est non conducteur la tension N(VDS4) est à un état bas ;
- une tension de réinitialisation Vrst4 ; et
- une tension de réinitialisation VrstPLL4 d'un autre circuit de l'unité de commande 402.

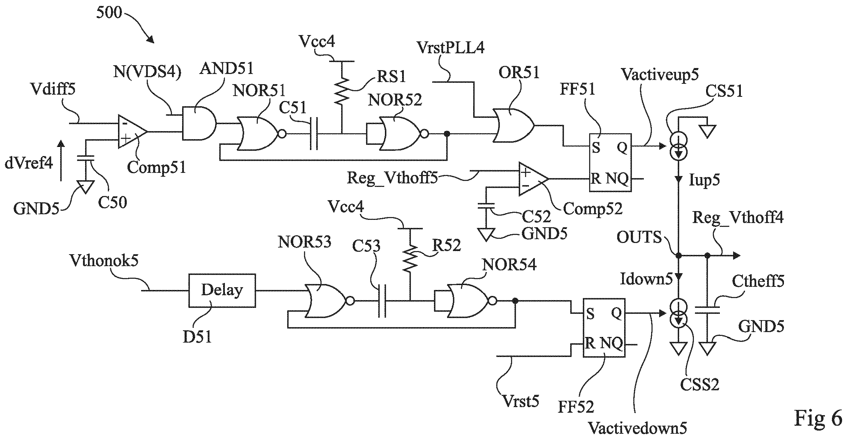

Un exemple de réalisation du circuit de génération 412 est décrit en relation avec la figure 6.

L'unité de commande 402 comprend, en outre, un circuit de gestion 413 (MNG) des états du transistor 150. Le circuit de gestion 413 reçoit, en entrée, les tensions de comparaison VComp2 et VComp3, et une tension de sortie N(VGPLL4) d'un autre circuit de l'unité de commande 402. Le circuit de gestion 413 fournit, en sortie, les tensions N(VDS4) et Vrst4, et une tension de commande Vset4. La tension de commande Vset4 a pour rôle d'envoyer l'instruction de mise en conduction du transistor 150 au circuit de pilotage 401, et donc de démarrer un cycle de conduction du transistor 150. La tension de commande Vrst4 a pour rôle d'envoyer l'instruction d'ouverture du transistor 150 au circuit de pilotage 401, c'est-à-dire l'instruction d'arrêt de conduction du transistor 150, et donc l'instruction permettant d'arrêter un cycle de conduction du transistor 150.

L'unité de commande 402 comprend, en outre, un circuit de mise en veille 414 recevant, en entrée, la tension VDS4, et fournissant en sortie un tension de mise en veille VStby4 envoyée au circuit de pilotage 401.

L'unité de commande 402 comprend, en outre, un circuit de régulation d'un délai 415 (PLL) permettant la régulation d'un délai tdn4 par rapport à une durée de référence tdoff4. Le circuit 415 reçoit, en entrée, les tensions Vset4, N(VDS4) et la tension de réinitialisation Vrst4, et fournit, en sortie, les tensions N(VGPLL4) et VrstPLL4.

L'unité de commande 402, comprend, en outre et pour finir, un circuit de gestion 416 (kVGS MNG) du niveau de la tension de commande appliquée au transistor 150. Le circuit de gestion 416 est optionnel dans ce mode de réalisation. Le circuit de gestion 416 reçoit, en entrée, la tension N(VGPLL4) et la tension VGS4, et fournit, en sortie, une tension de commande CMD_kVGS4 du niveau de la tension de commande du transistor 150. Le circuit de gestion 416 peut, en outre et de façon optionnelle, fournir une tension de commande Sup_kVGS4 indiquant que la tension de commande du transistor 150 a atteint le seuil fixé.

La figure 5 représente des chronogrammes illustrant le fonctionnement du mode de réalisation décrit en relation avec la figure 4 lorsque celui-ci est utilisé dans un circuit de conversion de tension du type des circuits présentés en relation avec les figures 2 et 3. Le dispositif de la figure 4 est, plus particulièrement, utilisé comme transistor dans l'étage secondaire de ces circuits de conversion de tension.

Plus particulièrement, la figure 5 représente les chronogrammes suivants :
- le chronogramme d'un courant ISD4 représentant le courant traversant le transistor 150, c'est-à-dire le courant entre les noeuds S et D ;
- le chronogramme d'un courant IBD4 représentant le courant traversant la diode parasite 151 du transistor 150 ;
- le chronogramme de la tension VDS4 entre les bornes de drain et de source du transistor 150 ;
- le chronogramme de la tension de seuil Reg_Vthoff4 par rapport à laquelle la tension VDS4 est comparée ;
- le chronogramme de la tension de seuil VTHON4 correspondant à un niveau seuil imposé aux bornes de conduction du transistor 150 à partir duquel la diode parasite 151 du transistor 150 est considérée comme conductrice ;
- le chronogramme de la tension de commande Vset4 de mise en conduction du transistor 150 ;
- le chronogramme d'une tension de commande Vsetdown4 interne au circuit 412 ;
- le chronogramme de la tension de réinitialisation VrstPLL4 du circuit 415 ;
- le chronogramme de la tension de commande Vrst4 d'arrêt de conduction du transistor 150 ;
- le chronogramme d'une tension VR5 interne au circuit 415 ;
- le chronogramme d'une tension de commande Ving4 interne au circuit 415 ;
- le chronogramme de la tension N(VDS4) représentant l'état de conductivité du transistor 150 ;
- le chronogramme de la tension VGPLL4 correspondant à l'inverse de la tension N(VGPLL4) ;
- le chronogramme d'une tension de commande VGtdoff4 interne du circuit 415 ;
- le chronogramme d'une tension de commande Vtdn4 interne du circuit 415 représentant le délai tdn4 ;
- le chronogramme d'une tension de commande Vtdoff4 interne du circuit 415 représentant le délai tdoff4 ;
- le chronogramme de la tension VGS4 de commande du transistor 150 ; et
- le chronogramme d'une tension kVGS4 du circuit de gestion 416.

A un instant initial t50, le transistor 150 est commandé pour ne pas être conducteur. Autrement dit, la tension VGS4 est à un état bas, c'est-à-dire est à un état, ou à un niveau, inférieur à la tension de seuil Vth du transistor 150. Les courants ISD4 et IBD4 traversant le transistor 150 et sa diode parasite 151 sont donc proches de zéro, par exemple nuls, et la tension VDS4 entre les bornes de conduction du transistor 150 est fonction du circuit dans lequel le transistor 150 est placé.

A l'instant initial t50, la plupart des tensions de commandes sont à un état bas. Plus particulièrement, les tensions Vset4, Vsetdown4, VrstPLL4, Vrst4, VGPLL4, VGtdoff4, Vtdoff4 sont à un état bas. Les tensions VTHON4 et kVGS4 sont des tensions de seuil constantes, par exemple supérieure à zéro. La tension de seuil Reg_Vthoff4 est à un niveau stable, par exemple de l'ordre de 0 V. La tension de seuil commandable Ving4 est à une valeur supérieure à zéro. La tension VR4 est une tension en rampe utilisée par le circuit de régulation 415, et est, par exemple, à une valeur supérieure à zéro à l'état initiale.

A un instant t51, postérieur à l'instant t50, un cycle de conduction du transistor 150 démarre. Autrement dit, à l'instant t51, une commande de mise en conduction, via la tension Vset4, est envoyée au circuit de pilotage 401 pour qu'il mette le transistor 150 en conduction. Pour cela, le circuit de pilotage augmente la tension VGS4 jusqu'à une première valeur supérieure à la tension de seuil Vth du transistor 150. Ainsi la tension VDS4 et le courant ISD4 voient leurs valeurs absolues augmenter, et présentent quelques oscillations avant de se stabiliser en une rampe décroissante, en valeur absolue, vers la valeur zéro.

De plus, comme un cycle de conduction du transistor 150 démarre, les tensions N(VDS4), VGPLL4, et VGtdoff4 passe à un état haut. La tension VR4 passe à un état bas, par exemple à zéro, et devient inférieure à la tension Ving4.

A un instant t52, postérieur à l'instant t51, il est considéré que les oscillations de la tension VDS4 et du courant ISD4 sont terminées, et l'adaptation de la tension de seuil commandable Reg_Vthoff4 peut démarrer. Selon un exemple, la durée comprise entre les instants t51 et t52, est un délai fixé à la fabrication du dispositif du mode de réalisation de la figure 4. Selon un exemple, ce délai est égale à au moins un tiers de la durée minimale d'un cycle de conduction du transistor 150. Lorsque le circuit de commande 400 et le transistor 150 sont utilisés dans l'une des applications des figures 1 ou 2, la durée d'un cycle de conduction est généralement définie par une fréquence de commutation.

Ainsi, à l'instant t52, la tension Vsetdown4 indique l'adaptation de la tension de seuil commandable Reg_Vthoff4 peut démarrer. Les autres tensions de commande ne sont pas modifiées, et la tension VR4 est toujours inférieure à la tension Ving4.

L'adaptation de la tension de seuil commandable Reg_Vthoff4 consiste à imposer, par régulation, un écart de tension dVref4 constant, appelée aussi tension dVref4, entre la tension Reg_Vthoff4 et la tension VDS4 pendant tout le cycle de conduction du transistor 150, c'est-à-dire jusqu'au moment où la tension Vrst4 indique la fin du cycle de conduction. Selon un exemple, la valeur de l'écart dVref4 est comprise entre 1 et 50 mV, par exemple de l'ordre de 10 mV. Un circuit permettant de générer la tension Reg_Vthoff4 est décrit en relation avec la figure 6.

A un instant t53, postérieur à l'instant t52, la tension VR4 dépasse la valeur de la tension de seuil Ving4, et le circuit 415 est réinitialisée via la tension VrstPLL4 qui passe à un état haut pendant une courte durée. A titre d'exemple, le circuit 415 peut comprendre un circuit comparateur prenant en entrée les tensions VR4 et Ving4 et fournissant en sortie la tension VrstPLL4. Selon un exemple, cette réinitialisation peut aussi être le résultat d'un changement d'état de la tension VRST4. Un procédé permettant d'ajuster la valeur de la tension Ving4 est alors démarré. Les tensions Vtdn4 et Vtdoff4 passent à un état haut.

De plus, à l'instant t53, une fonction optionnelle, mise en oeuvre par le circuit 416, commence son exécution. Cette fonction permet d'envoyer la tension de commande CMD-kVGS54 au circuit de pilotage permettant une adaptation du niveau de la tension de commande VGS4 à l'approche de la fin du cycle de conduction du transistor 150 et pendant le délai tdn4 définit précédemment. Pour cela, à partir de l'instant t53, la tension VGS4 est abaissée jusqu'à la valeur kVGS4 qui est comprise entre la tension seuil Vth du transistor 150 et la valeur précédente de la tension VGS4, pouvant être appelée valeur haute VGS4max de la tension VGS4.

A un instant t54, postérieur à l'instant t53, les tensions Vtdoff4 et VGtdoff4 passent à un état bas. La durée entre les instants t53 et t54 représente une durée de référence pendant laquelle il est acceptable que la diode parasite 151 soit conductrice.

A un instant t55, la tension Vtdn4 passe à un état bas suite au passage à l'état haut de la tension Vrst4. Si l'instant t55 est postérieur à l'instant t54, alors la valeur de la tension de seuil Ving4 est augmentée, et si l'instant t55 est antérieur à l'instant t54, alors la valeur de la tension de seuil Ving4 est diminuée.

De plus, à l'instant t55, la tension VDS4 entre les bornes D et S du transistor 150 commence à s'inverser et devient supérieure à la tension de seuil Reg_Vthoff4. Cela signifie que le cycle de conduction du transistor 150 est terminé. La tension Vrst4 passe alors brièvement à un état haut pour signifier la fin du cycle de conduction, et la tension de commande VGS4 est diminuée pour être inférieure à la tension seuil Vth du transistor 150. La tension N(VDS4) passe alors à un état bas.

A un instant t56, postérieur à l'instant t55, le cycle de conduction est terminée et la tension VDS4 change de signe, devient positive dans le cas de la figure 5. Si la tension Reg_Vthoff4 était restée constante, à une valeur proche de 0 V, par exemple de l'ordre de 0 V, alors la fin du cycle de conduction n'aurait été détectée qu'à l'instant t56 et non à l'instant t55.

Un avantage de ce mode de réalisation est qu'il permet d'éviter une surconsommation de courant au moment de la fin du cycle de conduction du transistor 150. En effet, la fin du cycle de conduction est donnée par le moment où la tension VDS4 commence à s'inverser. Dès que cette tension VDS4 s'inverse, la diode parasite 151 du transistor 150 est non conductrice mais peut entrainer une consommation de courant due à sa tension de claquage, qui peut aussi être appelée fuite de courant. En détectant cette inversion au plus tôt, la consommation de courant peut être diminuée.

La figure 6 représente un circuit 500 illustrant un exemple de réalisation du circuit 412 décrit en relation avec la figure 4.

Comme décrit en relation avec la figure 4, le circuit 500 reçoit, en entrée, les tensions VDS4, N(VDS4), Vrst4 et VrstPLL4, et fournit, en sortie, la tension de seuil commandable Reg_Vthoff4. De plus, le circuit 500 reçoit la tension d'alimentation VCC4.

Le circuit 500 comprend une première branche délivrant une première tension de commande interne Vactiveup5. La première branche reçoit :
- une tension Vdiff5 correspondant à la différence entre la tension VDS4, mesurée aux bornes de drain et de source du transistor 150, et la tension Reg_Vthoff4 ;
- la tension dVref4 constante ;
- la tension N(VDS4) ;
- la tension de réinitialisation VrstPLL4 ; et
- la tension d'alimentation VCC4.

La première branche comprend un condensateur C50 et un circuit comparateur Comp51 recevant sur son entrée inverseuse la tension Vdiff5, et sur son entrée non inverseuse la tension dVref4. Le condensateur C50 relie l'entrée non inverseuse du circuit comparateur Comp51 à un noeud de référence GND recevant un potentiel de référence, par exemple la masse. La valeur de la capacité du condensateur C50 permet de définir la valeur de la tension dVref4.

La première branche comprend, en outre, une porte logique AND51 de type ET, appelé aussi porte ET AND51. Une première entrée de la porte ET AND51 reçoit la tension N(VDS51), et une deuxième entrée de la porte ET AND5 reçoit la sortie du circuit comparateur Comp51.

La première branche comprend, en outre, une première porte logique NOR51 de type NON-OU, ou porte NON-OU NOR51, un condensateur C51, une résistance R51 et une deuxième porte NON-OU NOR52. La porte NON-OU NOR51 comprend une première entrée recevant la sortie de la porte ET AND51, et une deuxième entrée recevant la sortie de la porte NON-OU NOR52. La condensateur C51 relie la sortie de la porte NON-OU NOR51 aux deux entrées de la porte NON-OU NOR52. La résistance R51 relie un noeud recevant la tension d'alimentation VCC4 aux entrées de la porte NON-OU NOR52. Ces composants permettent de former un générateur d'impulsions de tension. La personne du métier saura utiliser un autre type de générateur d'impulsion de tension.

La première branche comprend, en outre et pour finir, un porte logique OR51 de type OU, aussi appelée porte OU OR51, un circuit comparateur Comp52, et une bascule FF51. Une première entrée de la porte OU OR51 reçoit la tension de réinitialisation VrstPLL4, et une deuxième entrée de la porte OU OR51 reçoit la sortie de la porte NON-OU NOR52. L'entrée non inverseuse du circuit comparateur Comp52 reçoit une tension Reg_Vthoff5 dont la valeur correspond à la valeur seuil que prend la tension Reg_Thoff4 en début de cycle de conduction du transistor 150 comme décrit en relation avec la figure 5. L'entrée inverseuse du circuit comparateur Comp52 est reliée au noeud de référence GND5 par l'intermédiaire du condensateur C52. La valeur de la capacité du condensateur C52 permet de définir la valeur de d'une tension de référence Vref_Vthoff5 appliquée à l'entrée inverseuse Comp52 correspondant à la valeur constante que prend la tension Reg_Vthoff4 en début de cycle de conduction comme décrit en relation avec la figure 5. La bascule FF51 comprend une entrée de commande S, une entrée de réinitialisation R, une sortie non inverseuse Q et une sortie inverseuse NQ. La sortie de la porte OU OR51 est reliée à l'entrée de commande S de la bascule FF51, et la sortie du circuit comparateur Comp52 est reliée à l'entrée de réinitialisation R de la bascule FF51. La sortie non inverseuse de la bascule FF51 fournit la tension de commande Vactiveup5.

Le circuit 500 comprend, en outre, une deuxième branche délivrant une deuxième tension de commande interne Vactivedown5. La deuxième branche reçoit la tension VCC4 et la tension Vrst5.

La deuxième branche comprend un circuit D51 d'ajout d'un délai, ou retard, permettant de fixer la durée entre les instants t51 et t52. Le circuit D51 reçoit, en entrée, un signal de commande interne Vthonok5, correspondant à la tension Vset4 décrite en relation avec les figures 4 et 5, destiné à être retardé pour obtenir le comportement décrit en relation avec la figure 5.

La deuxième branche comprend, en outre, une première porte logique NOR53 de type NON-OU, ou porte NON-OU NOR53, un condensateur C53, une résistance R52 et une deuxième porte NON-OU NOR54. La porte NON-OU NOR 53 comprend une première entrée recevant la sortie du circuit D51, et une deuxième entrée recevant la sortie de la porte NON-OU NOR54. Le condensateur C53 relie la sortie de la porte NON-OU NOR53 aux deux entrées de la porte NON-OU NOR54. La résistance R52 relie un noeud recevant la tension d'alimentation VCC4 aux entrées de la porte NON-OU NOR54. Ces composants permettent de former un générateur d'impulsions de tension. La personne du métier saura utiliser un autre type de générateur d'impulsion de tension.

La deuxième branche comprend, en outre et pour finir, une bascule FF52 comprenant une entrée de commande S, une entrée de réinitialisation R, une sortie non inverseuse Q et une sortie inverseuse NQ. La sortie de la porte NON-OU NOR54 est reliée à l'entrée de commande S de la bascule FF52, et l'entrée de réinitialisation R de la bascule FF52 reçoit la tension de réinitialisation Vrst4. La sortie non inverseuse de la bascule FF52 fournit la tension de commande Vactivedown5.

Le circuit 500 comprend, en outre et pour finir, deux sources de courant CS51 et CS52 et un condensateur Cthoff5. La source de courant CS51 est commandée par la tension Vactiveup5 et fournit un courant Iup5 à un noeud de sortie OUT5. La source de courant CS52 est commandée par la tension Vactivedown5 et fournit un courant Idown5 à un noeud de sortie OUT5. Le condensateur Cthoff5 est disposé entre le noeud de sortie OUT5 et le noeud de référence GND5.

Le fonctionnement du circuit 500 est le suivant. La tension Reg_Vthoff est fournie par la décharge du condensateur Cthoff5. La charge et la décharge du condensateur Cthoff5 sont opérées par les sources de courants CS51 et CS52, et sont donc commandées par les tensions Vactiveup5 et Vactivedown5. Entre les instants t51 et t52, la tension Reg_Vthoff4 est constante. Pour cela les sources de courant CS51 et CS52 sont désactivées. Le reste du temps, c'est-à-dire au moins après l'instant t52, la tension Reg_Vthoff4 n'est plus constante, pour cela les sources de courants sont activées et les courants Iup5 et Idown5 asservissent la tensions Vdiff5. C'est la tension Vsetdown4 qui donne l'activation des sources de courants CS51 et CS52.

La tension Vactiveup5 permet de fixer la tension Reg_Vthoff à la valeur de référence entre les instants t51 et t52, et la tension Vactivedownup5 permet de fixer la tension Reg_Vthoff pendant le reste du cycle de conduction du transistor 150.

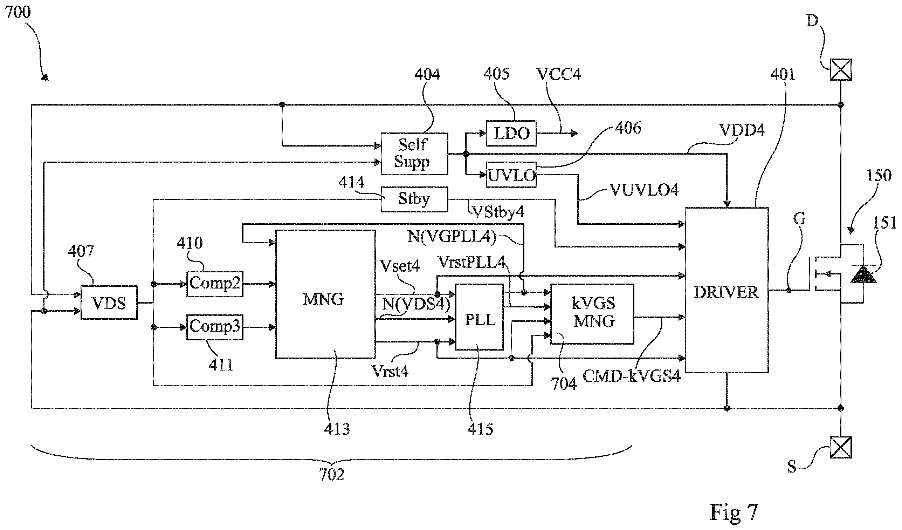

La figure 7 illustre, sous forme de blocs et de façon plus précise, un deuxième mode de réalisation d'un dispositif du type du dispositif de la figure 1. Plus particulièrement, la figure 7 illustre un deuxième mode de réalisation d'un dispositif électronique comprenant le transistor 150 et son circuit de commande 700 du type du circuit de commande 100 décrit en relation avec la figure 1.

Le circuit de commande 700 présente des éléments communs avec le circuit de commande 400 de la figure 4. Ces éléments ne seront pas décrits de nouveau et seules les différences entre les circuits 400 et 700 seront mises en exergue.

En particulier, le circuit de commande 700 comprend, comme le circuit de commande 100 de la figure 1 et le circuit 400 de la figure 4, un circuit de pilotage 401 (DRIVER) fournissant la tension de commande VGS4 au transistor 150. Pour cela, le circuit de pilotage 401 est relié, de préférence connecté, aux bornes G et S du transistor 150. De plus, le circuit de pilotage 401 reçoit une tension d'alimentation VDD4, et plusieurs tensions de commande détaillés ci-après.

Le circuit de commande 700 comprend, en outre, d'autres circuits faisant tous partie d'une unité de commande 702 du type de l'unité de commande 101 décrite en relation avec la figure 1 ou de l'unité de commande 402 décrit en relation avec la figure 4.

Comme l'unité de commande 402 de la figure 4, l'unité de commande 702 comprend :
- les circuits d'alimentation composés des circuits 404 (Self Supp), 405 (LDO) et 406 (UVLO) ;
- le circuit de mesure 407 (VDS) de la tension drain-source du transistor 150 ;
- le circuit de comparaison 410 (Comp2) et un circuit de comparaison 411 (Comp3) ;
- le circuit de gestion 413 (MNG) ;
- le circuit de mise en veille 414 (Stby) ; et
- le circuit de régulation d'un délai 415 (PLL).

A la différence de l'unité de commande 402, l'unité de commande 702 comprend un circuit de gestion 703 (MNG) remplaçant le circuit de gestion 413, et un circuit 704 (kVGS MNG) du niveau de la tension de commande appliquée au transistor 150 remplaçant le circuit de gestion 416 et le circuit 408. L'unité de commande 702 ne comprend ni le circuit de comparaison 411, ni le circuit de génération 412 de la tension Reg_Vthoff4. Ainsi, dans ce mode de réalisation, la tension VDS4 est comparée à la valeur de référence constante Vref_Vthoff5 définie en relation avec la figure 6.

De plus, le circuit de comparaison 410 reçoit, en entrée, la tension VDS4, et fournit en sortie une tension de comparaison VComp1. Le circuit de comparaison 410 est adapté à comparer la valeur de l'amplitude de la tension VDS4 à une tension de seuil VTHOFF-N(VDS4). Ce circuit de comparaison permet de générer la tension N(VDS4), et de forcer l'ouverture du transistor 150 dans le cas d'un diminution de la durée du cycle de conduction du transistor 150, ce qui peut arriver lorsque la tension Vtdn4 n'est pas générée.

Selon un mode de réalisation, le circuit de gestion 704 reçoit, en entrée, la tension N(VGPLL4), et fournit, en sortie, une tension de commande CMD_kVGS4 du niveau de la tension de commande du transistor 150. De plus, et contrairement au mode de réalisation de la figure 4, le circuit de gestion 704 n'est pas optionnel dans le dispositif 700.

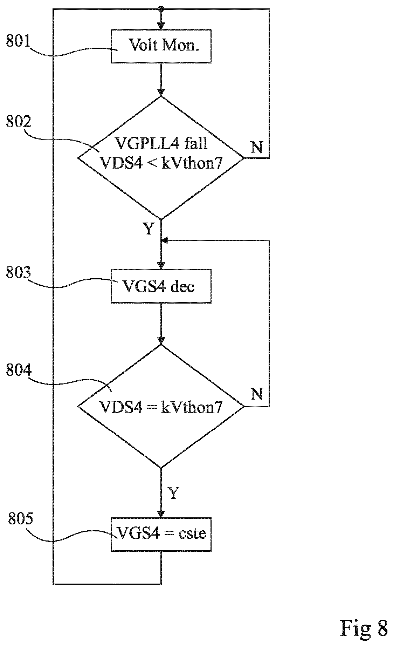

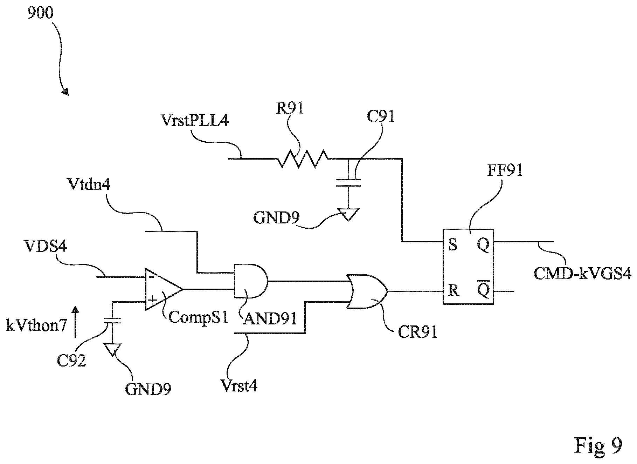

Comme décrit en relation avec les figures 4 et 5, le circuit de gestion 704 permet de fournir une commande au circuit de pilotage 401 pour qu'il réduise le niveau de la tension de commande VGS4 du transistor 150 lors de la fin du cycle de conduction, et plus particulièrement, de le réduire jusqu'à une deuxième valeur kVGS4 plus proche de la tension de seuil du transistor 150. Cependant, le circuit de gestion 704 et le circuit 415 permettent, en outre, d'envoyer des informations au circuit de pilotage pour qu'il commande le niveau de la deuxième valeur kVGS4 pour qu'elle soit au plus prêt de la tension de seuil Vth du transistor 150. La valeur de la deuxième valeur kVGS4 dépend de la valeur du courant traversant le transistor 150. Plus la valeur du courant diminue plus la valeur kVGS4 se rapproche de la tension de seuil Vth du transistor 150, et inversement. Le fonctionnement du circuit de gestion 704 est décrit en relation avec la figure 8, et un exemple de réalisation du circuit 704 est décrit en relation avec la figure 9.

La figure 8 est un schéma bloc illustrant le fonctionnement du circuit 704 décrit en relation avec la figure 7.

Comme décrit en relation avec la figure 6, lors de la fin du cycle de conduction du transistor 150, la tension de commande VGS4 peut être abaissée pour se rapprocher de la tension de seuil Vth du transistor 150.

A une étape initiale 801 (Volt Mon.), le cycle de conduction du transistor 150 est en cours et les tensions VDS4, VGS et VGPLL sont surveillées.

A une étape 802 (VGPLL4 Fall VDS4<kVthon7), la tension VGPLL présente un front descendant, et la tension VDS4 est inférieure (en valeur absolue) à une tension de seuil kVthon7. Tant que ces deux conditions ne sont pas réunies (sortie N du bloc de l'étape 802) l'étape suivante est l'étape 801, sinon l'étape suivante est une étape 803 (VGS4 dec.).

Selon un mode de réalisation, la tension de seuil kVthon7 est définie comme étant le résultat de la multiplication d'un coefficient k et de la tension de seuil VTHON4 représentant le seuil que la tension VDS4 dépasse lorsque la diode parasite 151 commence à conduire. Le coefficient k est choisi de façon à ce que la tension de commande VGS4 soit inférieure à la tension VGS4 maximale, mais supérieure à la tension de seuil Vth du transistor 150, et de façon à ce que le courant ISD4 continue de traverser le transistor 150, et permettant ainsi d'éviter la conduction de la diode parasite 151. Selon un exemple, le coefficient est compris entre un tiers et deux tiers.

A l'étape 803, la tension de commande VGS4 est diminuée, et la tension VDS4 est toujours surveillée. Tant que la tension VDS4 n'est pas égale à la tension seuil kVthon7, la tension VGS4 continue de diminuer.

A une étape 804 (VDS4 = kVthon7), la tension VDS4 est supérieure ou égale à la tension de seuil kVthon7, et l'étape suivante (sortie Y du bloc de l'étape 804) est une étape 805 (VGS4 = cste) pendant laquelle la tension VGS4 est gardée constante, et la tension VDS4 commence à diminuer (en valeur absolue). Comme dit précédemment, tant que la tension VDS4 n'est pas égale à la tension seuil kVthon7 (sortie N du bloc de l'étape 804), la tension VGS4 continue de diminuer.

Un avantage de ce mode de réalisation est qu'en diminuant la tension de commande VGS4 à l'approche de la fin du cycle de conduction du transistor 150 permet de limiter, et parfois d'éviter, les fuites de courant de recouvrement lors de la courte période de conduction de la diode parasite 151 du transistor 150.

La figure 9 représente un circuit 900 illustrant un exemple de réalisation du circuit 704 décrit en relation avec la figure 7, mis en oeuvre selon le fonctionnement décrit en relation avec la figure 8.

Comme décrit en relation avec la figure 7, le circuit 900 reçoit, en entrée, les tensions VDS4, VrstPLL4, Vrst4, et fournit, en sortie, la tension de commande CMD_kVGS4. De plus, le circuit 500 reçoit la tension de commande Vtdn4 décrite en relation avec la figure 5, et la tension de seuil kVthon7.

Le circuit 900 comprend une bascule FF91 fournissant en sortie la tension de commande CMD_kVGS4. La bascule FF91 comprend une entrée de commande S, une entrée de réinitialisation R, une sortie non inverseuse Q, fournissant la tension de commande CMD_kVGS4, et une sortie inverseuse NQ.

Le circuit 900 comprend, en outre, une résistance R91 et un condensateur C91. La résistance R91 reçoit sur une première borne la tension VrstPLL4, et a sa deuxième borne reliée, de préférence connectée, à l'entrée de commande S de la bascule FF91. Le condensateur C91 comprend une première borne reliée, de préférence connectée, à un noeud de référence GND9 recevant un potentiel de référence, par exemple la masse, et une deuxième borne reliée, de préférence connectée, à l'entrée de commande S de la bascule FF91.

Le circuit 900 comprend, en outre et pour finir, un circuit comparateur Comp91, un condensateur C92, une porte logique ET AND91 et une porte logique OU OR91. Le circuit comparateur Comp91 comprend une entrée inverseuse recevant la tension VDS4, et une entrée non inverseuse recevant la tension de seuil kVthon7. La tension de seuil kVthon7 est définie par la tension aux bornes du condensateur C92. Une première borne du condensateur C92 est reliée, de préférence connectée, à l'entrée non inverseuse du circuit comparateur Cimp91, et une deuxième borne du condensateur C92 est reliée, de préférence connectée, au noeud de référence GND9. La porte logique ET AND91 comprend une première entrée recevant la tension Vtdn4, et une deuxième entrée reliée à la sortie du circuit comparateur Comp91. La porte logique OU OU91 comprend une première entrée recevant la tension Vrst4, et une deuxième entrée reliée à la sortie de la porte ET AND91. La sortie de la porte OU OR91 est reliée à la borne de réinitialisation R de la bascule FF91.

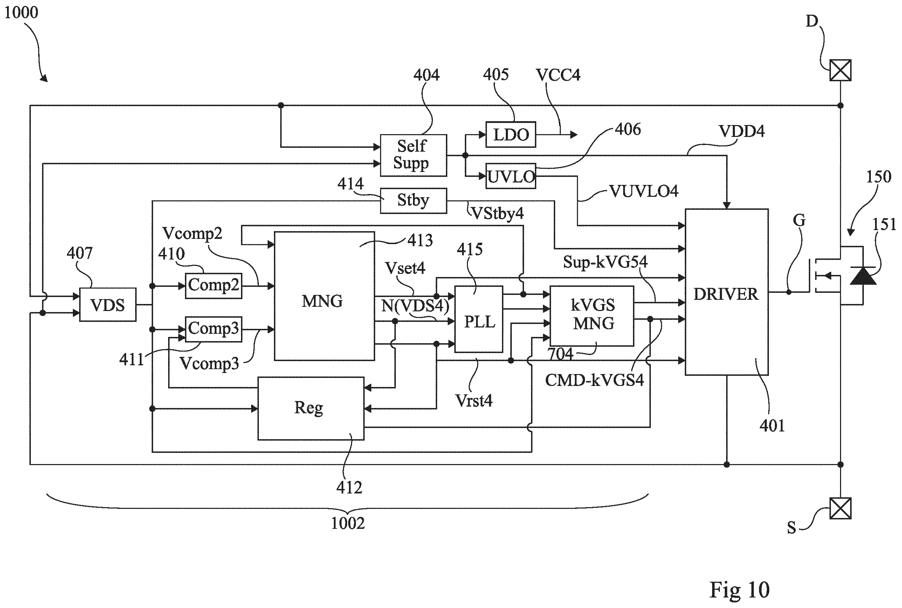

La figure 10 illustre, sous forme de blocs et de façon plus précise, un troisième mode de réalisation d'un dispositif du type du dispositif de la figure 1. Plus particulièrement, la figure 10 illustre un troisième mode de réalisation d'un dispositif électronique comprenant le transistor 150 et son circuit de commande 1000.

Ce mode de réalisation représente la combinaison des modes de réalisation des figures 4 et 7. Autrement dit, le circuit de commande 1000 met en oeuvre les fonctionnalités du circuit de commande 400 de la figure 4 et du circuit de commande 700 de la figure 7. Ainsi, le circuit de commande 1000 présente des éléments communs avec les circuits 400 et 700. Ces éléments ne seront pas décrits de nouveau et seules les différences entre le circuit 1000 et les circuits 400 et 700 seront mises en exergue.

En particulier, le circuit de commande 1000 comprend, comme les circuits 400 et 700, le circuit de pilotage 401 (DRIVER) fournissant la tension de commande VGS4 au transistor 150. Pour cela, le circuit de pilotage 401 est relié, de préférence connecté, aux bornes G et S du transistor 150. De plus, le circuit de pilotage 401 reçoit une tension d'alimentation VDD4, et plusieurs tensions de commande détaillés ci-après.

Le circuit de commande 1000 comprend, en outre, d'autres circuits faisant tous partie d'une unité de commande 1002 du type des unités de commande 101, 402 ou 702.

Comme l'unité de commande 402 de la figure 4 et l'unité de commande 702 de la figure 7, l'unité de commande 1002 comprend :
- les circuits d'alimentation composés des circuits 404 (Self Supp), 405 (LDO) et 406 (UVLO), le circuit 405 fournissant la tension d'alimentation VCC4 alimentant tous les circuits de l'unité de commande 702 et le circuit de pilotage 401 ;
- le circuit de mesure 407 (VDS) de la tension drain-source du transistor 150 ;
- les circuits de comparaison 410 (Comp2) et 411 (Comp3) ;
- le circuit de mise en veille 414 (Stby) ; et
- le circuit de régulation d'un délai 415 (PLL).

Comme l'unité de commande 402, l'unité de commande 1002 comprend le circuit de 412 de génération de la tension Reg_Vthoff4. Selon une variante non représentée, l'unité de commande 1002 pourrait, en outre, comprendre le circuit de comparaison 411 (Comp3) décrit en relation avec la figure **4****.**

Comme l'unité de commande 702, l'unité de commande 1002 comprend le circuit de gestion 703 (MNG), et le circuit 704 (kVGS MNG) du niveau de la tension de commande appliquée au transistor 150 remplaçant le circuit de gestion 416.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de commande d'un transistor (150) MOS à canal N, dans lequel, pendant un cycle de conduction dudit transistor, une première tension (VDS4) entre le drain et la source dudit transistor est comparée à une deuxième tension de seuil commandable (Reg_Vthoff4) et à une troisième tension (VTHON), et :
- lorsque la première tension (VDS4) est inférieure à la troisième tension (VTHON4), une quatrième tension de commande (VGS4), supérieure à une cinquième tension de seuil (Vth) dudit transistor (150), est appliquée entre la grille et la source dudit transistor (150) ;
- lorsque la première tension (VDS4) est supérieure à la deuxième tension (Reg_Vthoff4), la quatrième tension de commande (VGS4) est rendue inférieure à la cinquième tension de seuil (Vth) dudit transistor (150) et est appliquée entre la grille et la source dudit transistor (150),
dans lequel ladite deuxième tension (Reg_Vthoff4) est égale à :
- une première valeur constante (Ref_Vthoff5) entre un premier instant (t51) de mise en conduction dudit transistor (T150), et un deuxième instant (t52) de fin d'oscillations de la première tension (VDS4) et du courant (ISD4) traversant ledit transistor;
- une deuxième valeur variable, entre le deuxième instant (t52) et un troisième instant (t55), la deuxième valeur étant égale à la somme de la première tension (VDS4) et d'une sixième tension positive (dVref4) correspondant à un écart de tension constant, le troisième instant (t55) correspondant à l'instant où la première tension (VDS4) s'inverse.

2. Procédé selon la revendication 1, dans lequel la première valeur (Ref_Vthoff5) est égale à 0 V.

3. Procédé selon la revendication 1 ou 2, dans lequel une première durée comprise entre le premier instant (t51) et le deuxième instant (t52) est une durée constante correspondant au tiers de la durée totale d'un cycle de conduction du transistor (150).

4. Procédé selon l'une quelconque des revendications 1 à 3, dans lequel :
- avant un quatrième instant (t53) défini par l'égalité d'une huitième tension de rampe (VR4) avec une neuvième tension de seuil (Ving4), compris entre le premier instant (t51) et le troisième instant (t55), la quatrième tension de commande (VGS4) est rendue supérieure à la cinquième tension de seuil (Vth) dudit transistor (150) et est appliquée entre la grille et la source dudit transistor (150) ; et
- entre le quatrième instant (t53) et le troisième instant (t55), la quatrième tension de commande (VGS4) est diminuée jusqu'à une quatrième valeur (kVGS4) comprise entre la cinquième tension seuil (Vth) dudit transistor (150) et la valeur de la quatrième tension de commande (VGS4) au quatrième instant (t53).

5. Procédé selon la revendication 4, dans lequel entre le quatrième instant (t53) et le troisième instant (t55), la quatrième valeur (kVGS4) est atteinte lorsque la première tension (VDS4) est égale à une septième tension (kVthon7),
dans lequel la septième tension (kVthon7) est égale au produit d'un coefficient et de la troisième tension (VTHON4) représentant le niveau de tension entre les bornes de drain et de source dudit transistor (150) atteint lorsqu'une diode parasite (151) dudit transistor (150) est conductrice, et
dans lequel ledit coefficient est compris entre un tiers et deux tiers.

6. Procédé selon la revendication 4 ou 5, dans lequel le quatrième instant (t53) est compris entre le deuxième instant (t52) et le troisième instant (t55).

7. Circuit de commande (400 ; 1000) adapté à mettre en oeuvre le procédé selon l'une quelconque des revendications 1 à 6.

8. Dispositif électronique comprenant un circuit de commande selon la revendication 7.

9. Dispositif selon la revendication 8, comprenant, en outre, un transistor (150) de type MOS à canal N, et un circuit de pilotage (401) dudit transistor (150).

10. Dispositif (200 ; 300) de conversion de tension comprenant le dispositif selon la revendication 8 ou 9.

11. Dispositif selon la revendication 10, étant un convertisseur à découpage à transformateur (200).

12. Dispositif selon la revendication 10, étant un convertisseur de type élévateur (300).

13. Dispositif selon la revendication 10, étant un convertisseur de type buck (300).

## Patentansprüche

1. Ein Verfahren zum Steuern eines N-Kanal-MOS-Transistors (150), wobei während eines Leitzyklus des Transistors eine erste Spannung (VDS4) zwischen dem Drain und der Source des Transistors verglichen wird mit einer zweiten steuerbaren Schwellenspannung (Reg_Vthoff4) und mit einer dritten Spannung (VTHON), und:
- wenn die erste Spannung (VDS4) kleiner als die dritte Spannung (VTHON4) ist, wird eine vierte Steuerspannung (VGS4), die größer als eine fünfte Schwellenspannung (Vth) des Transistors (150) ist, zwischen dem Gate und der Source des Transistors (150) angelegt;
- wenn die erste Spannung (VDS4) größer als die zweite Spannung (Reg_Vthoff4) ist, wird die vierte Steuerspannung (VGS4) kleiner als die fünfte Schwellenspannung (Vth) des Transistors (150) eingestellt und zwischen dem Gate und der Source des Transistors (150) angelegt,
wobei die zweite Spannung (Reg_Vthoff4) gleich ist zu:
- einem ersten konstanten Wert (Ref_Vthoff5) zwischen einem ersten Zeitpunkt (t51) des Einschaltens des Transistors (T150) und einem zweiten Zeitpunkt (t52) des Schwingungsendes der ersten Spannung (VD54) und des Stroms (ISD4) durch den Transistor;
- einen zweiten variablen Wert zwischen dem zweiten Zeitpunkt (t52) und einem dritten Zeitpunkt (t55), wobei der zweite Wert gleich der Summe der ersten Spannung (VDS4) und einer sechsten positiven Spannung (dVref4) ist, die einem konstanten Spannungsoffset entspricht, und der dritte Zeitpunkt (t55) dem Zeitpunkt entspricht, an dem die erste Spannung (VDS4) invertiert.

2. Das Verfahren nach Anspruch 1, wobei der erste Wert (Ref_Vthoff5) gleich 0 V ist.

3. Das Verfahren nach Anspruch 1 oder 2, wobei eine erste Dauer, die zwischen der ersten Zeit (t51) und der zweiten Zeit (t52) besteht, eine konstante Dauer ist, die dem Drittel der gesamten Dauer eines Leitzyklus des Transistors (150) entspricht.

4. Das Verfahren nach einem der Ansprüche 1 bis 3, wobei:
- vor einer vierten Zeit (t53), die durch die Gleichheit einer achten Rampenspannung (VR4) mit einer neunten Schwellenspannung (Ving4) definiert ist, die zwischen der ersten Zeit (t51) und der dritten Zeit (t55) besteht, die vierte Steuerspannung (VGS4) über die fünfte Schwellenspannung (Vth) des Transistors (150) eingestellt wird und zwischen dem Gate und der Source des Transistors (150) angelegt wird; und
- zwischen dem vierten Zeitpunkt (t53) und dem dritten Zeitpunkt (t55) die vierte Steuerspannung (VGS4) auf einen vierten Wert (kVGS4) reduziert wird, der zwischen der fünften Schwellenspannung (Vth) des Transistors (150) und dem Wert der vierten Steuerspannung (VGS4) zum vierten Zeitpunkt (t53) liegt.

5. Das Verfahren nach Anspruch 4, wobei zwischen der vierten Zeit (t53) und der dritten Zeit (t55) der vierte Wert (kVGS4) erreicht wird, wenn die erste Spannung (VDS4) gleich einer siebten Spannung (kVthon7) ist,
wobei die siebte Spannung (kVthon7) gleich der Multiplikation eines Faktors mit der dritten Spannung (VTHON4) ist, die den Spannungspegel zwischen den Drain- und Source-Anschlüssen des Transistors (150) darstellt, der erreicht wird, wenn eine parasitäre Diode (151) des Transistors (150) leitend ist, und
wobei der Faktor zwischen einem Drittel und zwei Dritteln liegt.

6. Das Verfahren nach Anspruch 4 oder 5, wobei die vierte Zeit (t53) zwischen der zweiten Zeit (t52) und der dritten Zeit (t55) liegt.

7. Eine Steuerschaltung (400; 1000), die eingerichtet ist, um das Verfahren nach einem der Ansprüche 1 bis 6 zu implementieren.

8. Eine elektronische Vorrichtung mit einer Steuerschaltung nach Anspruch 7.

9. Die Vorrichtung nach Anspruch 8, ferner aufweisend einen N-Kanal-MOS-Transistor (150) und eine Treiberschaltung (401) für den Transistor (150).

10. Eine Vorrichtung (200; 300) zum Umwandeln einer Spannung, die die Vorrichtung nach Anspruch 8 oder 9 aufweist.

11. Die Vorrichtung nach Anspruch 10, die ein Schaltwandler mit Transformator (200) ist.

12. Die Vorrichtung nach Anspruch 10, die ein Boost-Wandler (300) ist.

13. Die Vorrichtung nach Anspruch 10, die ein Abwärtswandler (300) ist.

## Claims

1. A method for controlling a N-channel MOS transistor (150), wherein, during a conduction cycle of said transistor, a first voltage (VDS4) between the drain and the source of said transistor is compared to a second controllable threshold voltage (Reg_Vthoff4) and to a third voltage (VTHON), and:
- when the first voltage (VDS4) is smaller than a third voltage (VTHON4), a fourth control voltage (VGS4), greater than a fifth threshold voltage (Vth) of said transistor (150), is applied between the gate and the source of said transistor (150);
- when the first voltage (VDS4) is greater than the second voltage (Reg_Vthoff4), the fourth control voltage (VGS4) is brought smaller than the fifth threshold voltage (Vth) of said transistor (150) and is applied between the gate and source of said transistor (150),
wherein said second voltage (Reg_Vthoff4) is equal to:
- a first constant value (Ref_Vthoff5) between a first time (t51) of switching on said transistor (T150) and a second time (t52) of end of swing in the first voltage (VD54) and in the current (ISD4) through said transistor;
- a second variable value, between the second time (t52) and a third time (t55), the second value being equal to the sum of the first voltage (VDS4) and of a sixth positive voltage (dVref4) corresponding to a constant voltage offset, the third time (t55) corresponding to the time when the first voltage (VDS4) inverts.

2. The method according to claim 1, wherein the first value (Ref_Vthoff5) is equal to 0 V.

3. The method according to claim 1 or 2, wherein a first duration, comprised between the first time (t51) and the second time (t52), is a constant duration corresponding to the third of the whole duration of a conduction cycle of the transistor (150).

4. The method according to any of claims 1 to 3, wherein:
- before a fourth time (t53) defined by the equality of an eight ramp voltage (VR4) with a ninth threshold voltage (Ving4), comprised between the first time (t51) and the third time (t55), the fourth control voltage (VGS4) is brought greater than the fifth threshold voltage (Vth) of said transistor (150) and is applied between the gate and source of said transistor (150); and
- between the fourth time (t53) and the third time (t55), the fourth control voltage (VGS4) is reduced up to a fourth value (kVGS4) comprised between the fifth threshold voltage (Vth) of said transistor (150) and the value of the fourth control voltage (VGS4) at the fourth time (t53).

5. The method according to claim 4, wherein between the fourth time (t53) and the third time (t55), the fourth value (kVGS4) is reached when the first voltage (VDS4) is equal to a seventh voltage (kVthon7),
wherein the seventh voltage (kVthon7) is equal to the multiplication of a factor by the third voltage (VTHON4) representing the voltage level between the drain and source terminals of said transistor (150) reached when a parasitic diode (151) of said transistor (150) is conductive, and
wherein said factor is comprised between one third and two thirds.

6. The method according to claim 4 or 5, wherein the fourth time (t53) is comprised between the second time (t52) and the third time (t55).

7. A control circuit (400; 1000) adapted to implement the method according to any of claims 1 to 6.

8. An electronic device comprising a control circuit according to claim 7.

9. The device according to claim 8, further comprising a N-channel MOS-type transistor (150), and a driving circuit (401) of said transistor (150).

10. A device (200; 300) for converting a voltage comprising the device according to claim 8 or 9.

11. The device according to claim 10, being a switched-mode converter with transformer (200).

12. The device according to claim 10, being a Boost-type converter (300).

13. The device according to claim 10, being a Buck-type converter (300).
